# EUROPEAN PATENT APPLICATION

(11) **EP 4 489 535 A1**
(43) Date of publication of application: **08.01.2025**
(21) Application number: 23183625.5
(22) Date of filing: 05.07.2023
(51) Int. Cl.: H05K 5/02, H05K 7/20

(54) **EMERGENCY COOLING FOR LIQUID-COOLED SYSTEMS**

(71) Applicant: Harman Becker Automotive Systems GmbH, 76307 Karlsbad (DE)
(72) Inventor: NOSHADI, Valod, 76275 Ettlingen (DE)
(74) Representative: Kraus & Lederer PartGmbB

(57) **Abstract**

A liquid-cooled system comprises a primary cooling circuit designed to circulate a cooling liquid for the purpose of dissipating heat from a heat source. A cold plate assembly is thermally coupled to the heat source, facilitating the exchange of heat with the cooling liquid. In emergency situations, in which a failure of the regular cooling circuit may occur, the system activates an emergency cooling unit comprising a Phase Change Material (PCM) housed within a dedicated containment structure. A pair of distributor valves are mechanically linked to both the primary cooling circuit and the emergency cooling unit. These valves are configured to selectively disconnect the cold plate assembly from the primary cooling circuit and connect it to the emergency cooling unit when prompted by a control signal, thus providing emergency cooling functionality for a predetermined period of time.

## Description

### TECHNICAL FIELD

Various examples of the disclosure generally relate to the field of liquid-cooled hardware systems. Various examples of the disclosure specifically relate to emergency cooling systems for liquid-cooled systems in automotive applications.

### BACKGROUND

Within various industries, such as automotive, aerospace, and high-performance computing, hardware components often generate significant amounts of heat due to their operation. Specifically, high power and high heat density electronics are conventionally cooled by liquid-cooled systems. These systems employ cold plates to transfer the heat, which is then dissipated by circulating a cooling liquid through these plates. Nonetheless, there exists the risk of a cooling fluid loss or failure of the cooling system during regular operation. During such situations, it becomes crucial to maintain the operation of safety-critical features for a certain duration in an emergency mode to avert potential malfunctions or accidents. The thermal capacity of the cold plates and printed circuit boards (PCBs), however, is generally insufficient to support the emergency operation for the necessary duration. For instance, in the automotive sector, functions like digital cockpit operation, body control, and autonomous driving have to be kept functional for a predefined period of time.

### SUMMARY

Accordingly, there is a need for advanced techniques for these emergency scenarios, which alleviate or mitigate at least some of the above-identified restrictions and drawbacks.

This need is met by the features of the independent claims. The features of the dependent claims define further advantageous examples.

In the following, the solution according to the present disclosure will be described with regard to the claimed cooling systems as well as with regard to the claimed cooling methods, wherein features, advantages, or alternative embodiments can be assigned to the other claimed objects and vice versa. In other words, the claims related to the cooling systems can be improved with features described in the context of the cooling methods, and the cooling methods can be improved with features described in the context of the cooling systems. Further, any of cooling devices and /or control units and/or computer programs and/or computer-readable storage media may be improved with features described the context of the systems and methods.

A liquid-cooled system is provided, which is configured to provide emergency cooling to a heat source to be cooled. The liquid cooled system comprises a primary cooling circuit, or regular cooling circuit/system, through which a cooling liquid, also often referred to as coolant, is circulated for heat dissipation. A cold plate or cold plate assembly, which can be thermally connected to a heat source, transfers heat from the heat source to the cooling liquid, when the cooling liquid is circulated through the cold plates. In various examples, the cooling liquid in the primary cooling circuit may be dissipated to the surrounding environment or led to an outside of the liquid-cooled system by the primary cooling circuit, thereby effectively transferring the heat away from the heat source and out of the liquid-cooled system. The system further includes an emergency cooling unit comprising a Phase Change Material (PCM) housed within a containment structure, wherein the system is configured to provide emergency cooling to the heat source using the emergency cooling unit. A pair of distributor valves is mechanically linked to the primary cooling circuit and the emergency cooling unit. The valves can selectively disconnect the cold plate assembly from the primary cooling circuit and connect it to the emergency cooling unit, in response to a control signal. The emergency cooling unit may be used in emergency situations, when the primary cooling circuit does not work, wherein the cooling liquid is cooled using the emergency cooling unit, as will be describe in the following in more detail.

In various examples, the primary cooling circuit may also be referred to as the main or regular cooling circuit or system. In regular operation, the cooling liquid is circulated in the primary cooling circuit of the liquid-cooled system. The cooling liquid is pumped into the cold plate assembly, which is thermally coupled to the heat source. Here, the cooling liquid absorbs the heat generated by the heat source. After absorbing heat from the heat source, the heated cooling liquid flows away from the cold plate assembly and moves towards a heat exchanger in the primary cooling circuit. The heat exchanger can be an air-cooled radiator, a water-cooled condenser, or another type of cooling device, which dissipates the heat from the cooling liquid to the surrounding environment or another cooling medium. Inside the heat exchanger, the cooling liquid releases the absorbed heat, thereby cooling down. The heat is transferred to the surrounding environment or the secondary cooling medium, such as air or water, which is then expelled from the system, thus completing the heat exchange process. After the cooling liquid has been cooled in the heat exchanger, it is recirculated back to the cold plate assembly, where it can once again absorb heat from the heat source. This continuous circulation of cooling liquid through the primary cooling circuit allows for the consistent and effective heat transfer from the heat source in regular operation. This helps maintain the heat source, typically high-power electronics, within a safe operating temperature range.

The cold plate assembly, also known as a heat sink or heat exchanger, facilitates heat transfer from the heat source to the cooling liquid. The cold plate assembly is thermally coupled to the heat source, meaning that it is positioned in such a way that it can effectively absorb heat from the heat source. In direct contact, the cold plate assembly can be physically attached to the heat source, typically through a thermal interface material (TIM) that fills any air gaps and provides a highconductivity path for heat transfer. The TIM could be a thermal grease, pad, or adhesive that is applied between the cold plate assembly and the heat source. In indirect contact, the cold plate assembly could be connected to a heatsink that is directly attached to the heat source. The heatsink absorbs heat from the heat source and then transfers it to the cold plate assembly. This can be used when the heat source's surface is not suitable for direct contact with the cold plate.

In various examples, the heat source can comprise high-power electronics in an automotive application or in a vehicle. These can include, for example, the electronics for a digital cockpit, autonomous driving systems, and other electronic systems in a vehicle that generate substantial amounts of heat. These systems need to be cooled to maintain their performance and reliability.

The distributor valves can also be referred to as switching valves or control valves. Distributor valves are mechanical devices included within the flow path of the cooling liquid. They are designed to control the direction of the cooling liquid flow between the primary cooling circuit and the emergency cooling unit. Distributor valves can be situated in points within the cooling system's tubing or piping. They serve as junctions where the flow path can be alternated. When in their default position, the distributor valves allow the cooling liquid to flow from the primary cooling circuit to the cold plate assembly, enabling regular operation of the cooling system. Upon receiving a control signal, such as when a failure is detected in the primary cooling circuit, the distributor valves switch positions. They disconnect the flow path from the primary cooling circuit and connect the cold plate assembly to the emergency cooling unit. This effectively reroutes the cooling liquid to the emergency cooling unit, initiating emergency operation of the cooling system. The distributor valves can be located in such a way that the flow path directly before the cold plate assembly (which is in direct thermal contact with the heat source) is shared between regular and emergency operation. This design allows for a smooth transition between the primary cooling circuit and the emergency cooling unit, ensuring that the heat source can continue to be cooled even in case of a failure in the primary cooling circuit. The cooling liquid, whether from the primary cooling circuit or the emergency cooling unit, is thus able to continuously cool the heat source, maintaining the system's performance and safety.

This formation of the distributor valves and their operation essentially creates an emergency cooling circuit, which can be activated when the primary cooling circuit fails. The control signal could be triggered by a variety of conditions, including a failure or irregular operation within the primary cooling circuit, or excessive heat generation from the heat source.

The emergency cooling circuit may include a pump for enabling the circulation of the cooling liquid through the cold plate assembly and the emergency cooling unit during the emergency operation mode. This pump, when activated, ensures flow of the cooling liquid through the emergency cooling unit, enabling heat exchange between the cooling liquid and the PCM.

The emergency cooling unit comprises a Phase Change Material (PCM), which enables emergency cooling when the primary cooling circuit fails. The cooling effect in the emergency cooling unit is enabled by the PCM as heat sink.

The PCM contained within the emergency cooling unit is a material that absorbs or releases thermal energy when it changes phase. Common examples of PCMs include paraffin waxes, salt hydrates, and certain types of polymers, although the exact type of PCM used would be selected based on factors such as its melting point and its thermal storage capacity.

The function of the PCM in the emergency cooling unit is to absorb and store heat from the cooling liquid during an emergency situation. When the cooling liquid from the primary cooling circuit is rerouted to the emergency cooling unit, it comes into contact with the PCM. The PCM, which is in a solid state, absorbs the heat from the cooling liquid and changes to a liquid state, a process known as melting. This phase change occurs at a constant temperature, and the amount of heat absorbed (the latent heat of fusion) is substantial, allowing the PCM to absorb and store a large amount of thermal energy.

The emergency cooling unit can also contain cooling fins or other heat exchange elements to increase its surface area, enhancing heat transfer between the cooling liquid and the PCM. These elements can be designed in various shapes and sizes, and they can be arranged in various configurations to optimize heat transfer.

The emergency cooling unit could also be referred to as a thermal reservoir or buffer unit. It is designed to provide temporary, emergency cooling in the event of a failure in the primary cooling circuit, wherein the heat is no longer transferred to the outside of the liquid-cooled system, but stored within the emergency cooling unit, in the PCM by the phase change.

The emergency cooling unit is a thermally independent module that houses a Phase Change Material (PCM). The phrase thermally independent refers to the fact that the emergency cooling unit is separate from the primary cooling circuit under regular operation conditions. It is not involved in the regular cooling process but is used to provide emergency cooling only. Therefore, the regular and emergency cooling circuits may not be operated simultaneously, but selectively switched.

The emergency cooling unit may be thermally isolated from its surrounding environment, except for the inflow and outflow of cooling liquid in the emergency operation mode.

The emergency cooling unit is formed by a containment structure filled with the PCM. The containment structure can be a sealed and/or insulated box or container that is designed to maintain the PCM in a stable state. It is designed to isolate the PCM from the surrounding environment and the primary cooling circuit, preventing unnecessary heat transfer and ensuring that the PCM's thermal reservoir can be used for emergency situations.

The emergency cooling unit can be situated close to or remotely from the heat source. It can be connected to the cold plate assembly via pipes or tubes, allowing the cooling liquid to be transported to and from the emergency cooling unit.

The emergency cooling unit is designed to be thermally decoupled from the surrounding environment, the heat source, and the primary cooling circuit under regular operation. The decoupling ensures that the thermal energy stored in the Phase Change Material (PCM) inside the emergency cooling unit is not prematurely exhausted and is available for an emergency.

The thermal decoupling is achieved primarily through the containment structure that houses the PCM. This structure can be designed and fabricated from materials with low thermal conductivity, such as certain plastics or composites. Additionally, the structure can incorporate insulation layers to further reduce heat exchange with the surrounding environment.

During regular operation, the distributor valves in the cooling system ensure that the cooling liquid flows only through the primary cooling circuit and does not enter the emergency cooling unit. This maintains the thermal decoupling of the emergency cooling unit from the heat source and the primary cooling circuit. Consequently, the solid state of the PCM is preserved, and the emergency cooling unit remains in standby mode.

However, when the system enters emergency operation-typically due to a failure or disruption in the primary cooling circuit-the distributor valves switch positions in response to a control signal.

This reroutes the flow of the cooling liquid from the primary cooling circuit to the emergency cooling unit by means of a pump integrated in the emergency cooling circuit. As a result, the emergency cooling unit becomes thermally coupled with the heat source via the cooling liquid.

In this state, the cooling liquid absorbs heat from the heat source and transports it to the emergency cooling unit, where it is absorbed by the PCM. The PCM undergoes a phase change, absorbing the heat from the cooling liquid, and thereby cooling it down before it is recirculated back to the heat source. Accordingly, the emergency cooling unit can store excess heat, which comes into the emergency cooling unit by cooling liquid, that is over a predefined melting temperature of the PCM, for a predefined period of time.

This mechanism ensures a continuous cooling effect during emergency operation, while a failure in the primary cooling circuit occurs. After the emergency operation, the emergency cooling unit can be recharged (i.e., the PCM can be solidified again).

Thereby, the ability of the cooling system to switch from the primary cooling circuit to an emergency cooling unit (i.e., the emergency cooling unit) ensures continuous cooling of the heat source even during a failure of the primary cooling circuit, allowing up-time of the system in case of a failure of the primary cooling system.

The liquid-cooled system can further include a control unit. The control unit can be configured to monitor the primary cooling circuit, and/or the emergency cooling unit, and/or the heat source. It can be configured to determine operating status of the primary cooling circuit based on the monitoring. It can generate the control signal that triggers the distributor valves based on the operating status of these monitored components and/or sensors. The control unit can also be referred to as a control module or control system. It is responsible for managing the operation of the cooling system. It monitors the status of different components and, based on the observed conditions, generates a control signal that activates the distributor valves and switches between the primary and the emergency cooling circuits.

The control unit can be responsible for monitoring various further elements within the system, interpreting inputs, and generating a control signal for the distributor valves. The control unit can receive various inputs, as will be described in detail in the following.

One or more pressure sensors and temperature sensors can be located at different points in the system, including the heat source, the primary cooling circuit, and the emergency cooling unit. These sensors may continuously monitor the temperature and pressure within the primary cooling circuit and may send this data to the control unit. If the a pressure drop occurs below a pressure threshold, or temperature at the heat source or within the primary cooling circuit rises above a predefined threshold, this could indicate a failure in the primary cooling circuit and trigger the control unit to activate the emergency cooling unit. On the other hand, if the temperature within the emergency cooling unit reaches a predefined maximum, the control unit could use this, and data from sensors in the primary cooling circuit, as input to signal the distributor valves to reconnect the cold plate assembly to the primary cooling circuit, indicating the end of the emergency cooling operation. In particular, a decrease of a pressure of the cooling liquid in the primary cooling circuit below a pressure threshold can indicate an emergency situation in the primary cooling system. In various examples, the control device can also receive information about an emergency situation, or sensor data, from a communication network within the vehicle.

For example, cooling liquid flow rate sensors can be placed in the primary cooling circuit to monitor the rate of cooling liquid flow. If the cooling liquid flow rate falls below a certain level, this could suggest a blockage or leak in the primary cooling circuit, and the control unit could generate a control signal to initiate the emergency cooling operation.

The control unit could also receive inputs from other types of sensors, such as pressure sensors to monitor cooling liquid pressure, or humidity sensors to detect cooling liquid leakage.

The control unit could be linked to a user interface from where it can receive manual inputs from a user or operator. This could be used, for instance, to manually initiate the emergency cooling operation or to adjust the thresholds that determine when the control unit generates a control signal.

Using these inputs, the control unit is configured to determine the operating state of the cooling system. If the control unit detects an abnormal condition in the primary cooling circuit (such as pressure drop, elevated temperatures, decreased flow rate, or decreased pressure), it generates a control signal to activate the distributor valves.

Accordingly, the control signal triggers the distributor valves to switch from their regular position, in which they couple the cold plate assembly to the primary cooling circuit, to their emergency position, in which they couple the cold plate assembly to the emergency cooling unit. This change in valve positioning reroutes the cooling liquid flow from the primary cooling circuit to the emergency cooling unit, initiating the emergency cooling operation.

Thereby, the addition of a control unit that adds intelligence to the system. It ensures that the system can respond appropriately to changes in the operating conditions, improving the reliability and effectiveness of the cooling system.

The liquid-cooled system could further be configured to operate in different operation modes. The regular operation mode involves cooling the liquid through the primary cooling circuit, with the distributor valves connecting the cold plate assembly to the primary cooling circuit and preventing the cooling liquid from entering the emergency cooling unit. The emergency operation mode involves the distributor valves disconnecting the cold plate assembly from the primary cooling circuit in response to the control signal and connecting it to the emergency cooling unit, allowing the cooling liquid to be cooled by the emergency cooling unit by use of a small pump in the emergency circuit.

Thus, the two operation modes can also be referred to as regular and emergency operation modes. The distributor valves can selectively connect the cold plate assembly to the primary cooling circuit or the emergency cooling unit based on the cooling requirements.

The liquid-cooled system could potentially incorporate several additional operation modes beyond the regular and emergency modes already described. These could enhance the system's versatility, efficiency, and longevity.

One additional operating mode is filling the system with cooling liquid for the first time or filling the system after a cooling liquid loss incident.

For example, after the emergency cooling operation, the Phase Change Material (PCM) in the emergency cooling unit would be in its liquid phase, having absorbed heat from the cooling liquid. In a recharging mode, the system would work to solidify the PCM again, restoring its ability to absorb heat in future emergency situations. The recharging of the emergency unit can be performed passively, without specific process. It would at least be possible, that recharging could be facilitated by connecting the emergency cooling unit to a cooling circuit in the vehicle. The control unit could monitor the PCM's temperature and switch to the recharging mode when it detects that the PCM is in its liquid phase and that conditions are suitable for recharging.

A predictive mode could leverage advanced analytics and machine learning techniques. The control unit could be equipped with a trained model that uses historical and real-time sensor data to predict potential failures in the primary cooling circuit based on the continuous monitoring of various sensors. If the model predicts a failure with a high degree of confidence, the system could initiate the emergency cooling operation, ensuring uninterrupted cooling of the heat source. This approach could help to avoid damage to the heat source and maintain system performance without rise of heat source temperature.

Under certain conditions, it could be beneficial to cool the PCM in the emergency cooling unit, particularly if ambient temperatures are high. In this mode, the control unit could use sensor data (e.g., ambient temperature, PCM temperature) to decide when to initiate the PCM-cooling mode. This could involve connecting the emergency cooling unit to a low-temperature circuit in the vehicle or using thermoelectric cooling modules to reduce the PCM's temperature. Lowering the PCM's temperature could increase its capacity to absorb heat during the next emergency cooling operation.

In certain situations, it might be beneficial to simultaneously use the primary cooling circuit and the emergency cooling unit to cool the heat source. In this hybrid mode, the distributor valves could be controlled in a way that allows partial cooling liquid flow to the emergency cooling unit. This could be advantageous, for instance, when the heat source is expected to generate higher-thanusual thermal loads.

The inclusion of these additional modes could increase the robustness of the cooling system and optimize its performance under varying operating conditions, contributing to the overall reliability and safety of the system.

The Phase Change Material (PCM) in the emergency cooling unit can have a melting point within a predefined temperature range that allows it to absorb heat from the cooling liquid while maintaining the cooling liquid between predefined cooling liquid temperature limits. The Phase Change Material can be a substance that has a melting point within a specific range suitable for absorbing heat from the cooling liquid. This substance transitions from solid to liquid (or vice versa) within the defined temperature range. Thereby, the PCM can absorb heat at a nearly constant temperature. This feature allows the cooling system to maintain the temperature of the heat source within a predefined range during emergency operation, ensuring safe and reliable operation of the heat source.

The control unit can be configured to detect a failure in the primary cooling circuit and generate the control signal in response to the detected failure. The control unit's failure detection can involve monitoring parameters such as cooling liquid temperature, cooling liquid flow rate, and pressure within the primary cooling circuit. An abnormality in these parameters can indicate a failure in the primary cooling circuit. Thereby, the control unit can detect a failure in the primary cooling circuit and respond appropriately. This feature enhances the reliability of the cooling system and ensures the safe operation of the heat source during a failure of the primary cooling circuit.

The heat source can comprise high-power and/or high-heat-density electronics in an automotive application. The high-power electronics can include components such as processors, power supplies, motor controllers, and other components that generate significant heat during operation. This enhances the reliability and safety of these electronic systems, which are critical to the functioning and performance of modern vehicles.

The emergency cooling unit can be thermally isolated from the surrounding environment and the primary cooling circuit by the containment structure. The containment structure can be designed to minimize thermal interaction between the PCM and the surrounding environment. It can be composed of a material that has high thermal resistance. Thereby it is possible to maintain the PCM in a ready state by reducing heat absorption from the environment. This feature ensures that the PCM can provide effective cooling when the system switches to emergency mode.

The control unit may receive and/or use input from at least one pressure sensor, and/or temperature sensor and/or at least one cooling liquid flow rate sensor in the primary cooling circuit to determine the operating status, in particular an emergency situation, of the primary cooling circuit. The pressure sensor, temperature sensor and the cooling liquid flow rate sensor can provide real-time data about the operation of the primary cooling circuit. These sensors can help in detecting anomalies such as overheating and insufficient cooling liquid flow.

The control unit can be configured to monitor the temperature of the heat source based on data received from a temperature sensor. The temperature sensor can provide real-time data about the temperature of the heat source. It can help the control unit to monitor the effectiveness of the cooling system and to detect potential overheating situations. This ensures that the heat source is operating within a safe temperature range, enhancing the reliability and safety of the system.

The control unit can be further configured to receive data from a temperature sensor, or pressure sensor within the emergency cooling unit and generate the control signal based on the data from the temperature sensor within the emergency cooling unit. The temperature sensor within the emergency cooling unit can provide data about the PCM in the emergency cooling unit. This sensor can help the control unit decide when to switch to emergency mode, and how long to switch to emergency mode. This ensures that the system switches to emergency mode when the PCM can provide effective cooling, enhancing the reliability and safety of the system.

The control unit can be configured to communicate with a user interface, providing alerts and updates on the status of the cooling system to a user. The user interface can provide visual and/or audible alerts and updates about the operating conditions of the cooling system. It can help operators or drivers respond to emergency situations promptly. This enhances the user's ability to respond to emergency situations, improving the safety and reliability of the system.

The distributor valves can be configured to automatically reconnect the cold plate assembly to the primary cooling circuit when the emergency cooling unit reaches a predefined temperature. The distributor valves can be set to re-engage the cold plate assembly with the primary cooling circuit upon detecting that the PCM in the emergency cooling unit has reached a temperature indicative of its exhaustion or reduced effectiveness.

Thereby, the cooling system can automatically switch back to the primary cooling circuit once the emergency cooling unit's cooling capacity is diminished. This feature ensures optimal utilization of cooling resources and further enhances the reliability of the system.

The distributor valves can be designed to provide a liquid and airtight seal when in closed position to prevent cooling liquid leakage and maintain thermal isolation of the emergency cooling unit. The distributor valves can also be described as being able to create a hermetic seal. They are designed to prevent any cooling liquid from leaking the cooling system or mixing between the primary and secondary cooling systems. Thereby, the valves can prevent cooling liquid leakage, ensuring the cooling system remains closed and segregated. This feature is vital for maintaining system pressure and preventing the mixing of different cooling liquids, contributing to the overall reliability and safety of the system.

The emergency cooling unit can be sized based on the cooling capacity of the system during a predefined period of emergency operation. The emergency cooling unit can be designed with a specific size or volume of PCM to meet the cooling requirements during the predefined emergency operation period. This sizing can be based on factors such as the heat generation rate of the heat source and/or the cooling capacity of the PCM and/or the desired emergency operation time. The thermal capacity of the emergency cooling unit can be sized such that the cooling liquid can be kept within regular operation temperature range at least 5 minutes, or at least 10 minutes, or at least 20 minutes. This ensures the heat source can operate safely during this period, enhancing the reliability and safety of the system.

A corresponding method for emergency cooling in liquid-cooled systems is provided, comprising monitoring the primary cooling circuit through a control unit, generating a control signal based on the status of the primary cooling circuit, disconnecting a cold plate assembly from the primary cooling circuit and connecting the cold plate assembly to an emergency cooling unit containing a Phase Change Material within a containment structure in response to the control signal, and cooling the cooling liquid using the PCM in the emergency cooling unit.

This method can be performed, for example, by any cooling system as described throughout the present disclosure and enables operation of the liquid-cooled system in an emergency situation, where the primary cooling circuit is malfunctioning or insufficient for cooling needs.

A control unit can be configured for carrying out a method according to the present disclosure, the computing device comprising a memory, an interface, and at least one processing unit, the memory containing instructions executable by said at least one processing unit, wherein execution of the instructions causes the computing device to execute any method or combination of methods according to the present disclosure.

A computer program, or computer program product, can comprise program code to be executed by at least one processor of a computing device. Therein, the execution of the program code causes the at least one processor to execute one of the methods according to the present disclosure.

A computer-readable storage medium can comprise instructions which, when executed by a processor, cause the processor to carry out any method or combination of methods according to the present disclosure.

For such a control unit, method for operating a cooling system, computer program, and computer-readable storage medium for operating a liquid cooled system, technical effects may be achieved, which correspond to the technical effects described for the cooling system.

It is to be understood that the features mentioned above and features yet to be explained below can be used not only in the respective combinations indicated, but also in other combinations or in isolation, without departing from the scope of the present disclosure. In particular, the features mentioned above and those yet to be explained below may be used not only in the respective combinations indicated, but also in other combinations or in isolation without departing from the scope of the disclosure.

Therefore, the above summary is merely intended to give a short overview over some features of some embodiments and implementations and is not to be construed as limiting. Other embodiments may comprise other features than the ones explained above.

### BRIEF DESCRIPTION OF THE DRAWINGS

These and other objects of the invention will be appreciated and understood by those skilled in the art from the detailed description of the preferred embodiments and the following drawings in which like reference numerals refer to like elements.
FIG. 1 schematically illustrates an overview of a liquid-cooled system, according to various embodiments.
FIG. 2 schematically illustrates the cooling liquid flow path during regular operation of the liquid-cooled system of FIG. 1, according to various embodiments.
FIG. 3 schematically illustrates the cooling liquid flow path during emergency operation of the liquid-cooled system of FIG. 1, according to various embodiments.
FIG. 4 illustrates steps of a method for emergency cooling that can be carried out by the liquid-cooled system of FIG. 1, according to various embodiments.

### DETAILED DESCRIPTION OF EXAMPLES

In the following, embodiments of the invention will be described in detail with reference to the accompanying drawings. It should be understood that the following description of embodiments is not to be taken in a limiting sense. The scope of the invention is not intended to be limited by the embodiments described hereinafter or by the drawings, which are taken to be illustrative examples of the general inventive concept. The features of the various embodiments may be combined with each other, unless specifically noted otherwise.

The drawings are to be regarded as being schematic representations, and elements illustrated in the drawings are not necessarily shown to scale. Rather, the various elements are represented such that their function and general purpose become apparent to a person skilled in the art. Any connection or coupling between functional blocks, devices, components, or other physical or functional units shown in the drawings or described herein may also be implemented by an indirect connection or coupling. A coupling between components may also be established over a wireless connection. Functional blocks may be implemented in hardware, firmware, software, or a combination thereof.

Hereinafter, techniques will be described that relate to cooling systems that use a cooling liquid. The liquid-cooled systems may be liquid-cooled automotive systems, or liquid-cooled systems in or onboard a vehicle. In various examples, the described techniques also be referred to as liquid cooling methods or emergency cooling methods, respectively systems.

In general, techniques are described that create an emergency cooling circuit for liquid-cooled systems, particularly in vehicles. When a primary cooling system, or sub-system, fails or stops working, an emergency cooling system, or sub-system, is activated and maintains operation for a defined period of time to allow for mitigation and intervention steps, while the regular cooling circuit remains nonoperational or with reduced operability.

The described systems utilize a Phase Change Material (PCM) to absorb heat at a constant temperature and cool the cooling liquid. When the primary cooling system fails, distributor valves disconnect the cold plate from the vehicle's cooling cycle and connect it to the emergency cooling system filled with PCM. This ensures that crucial systems like digital cockpit, body control, and autonomous driving can still function for a certain amount of time in an emergency, thus preventing accidents.

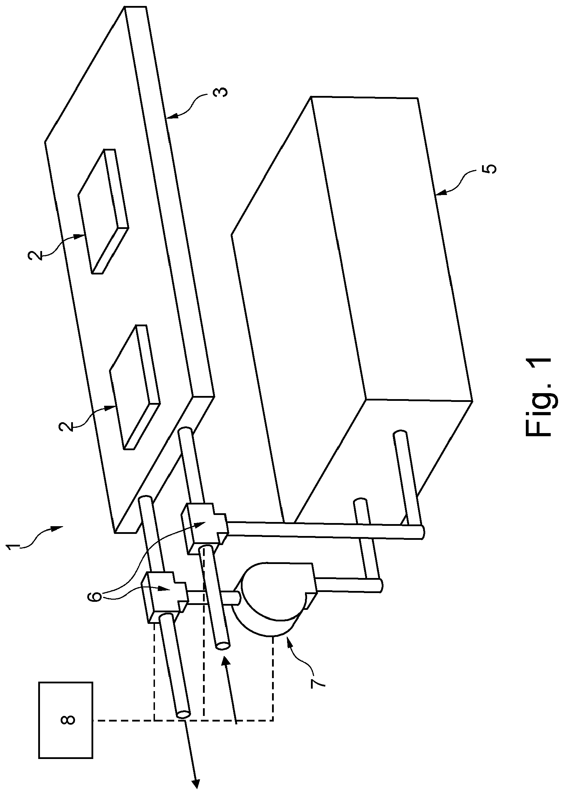

FIG. 1 schematically illustrates an overview of a liquid-cooled system 1, according to various embodiments.

As can be seen in FIG. 1, a liquid-cooled system 1 comprises a primary cooling circuit which is connected to a vehicle cooling circuit, as indicated by the arrows, that circulates a cooling liquid coming from the vehicle cooling circuit through the cold plate 3 to dissipate heat from two heat sources 2, in this case high-power electronics in an automotive application, as indicated by the arrow pointing into the liquid-cooled system. The cooling liquid which stores the heat from the heat sources is circulated back into the vehicle cooling circuit, as indicated by the arrow pointing out of the liquid-cooled system 1. The liquid-cooled system 1 further comprises a cold plate 3, thermally connected to the heat sources 2 (also referred to as cold plate assembly), designed to dissipate heat from the heat sources 2 and transfer the heat to the circulating cooling liquid, which is to be understood as a regular or regular cooling circuit, operating in regular operation mode. In regular operation, the heat may for example be dissipated to the surrounding environment by means of a secondary cooling circuit or fan or similar known techniques.

The liquid-cooled systems 1 of FIGs. 1 to 3 further include a control unit 8, that is configured to control the distributor valves 6 and pump 7 in liquid-cooled systems 1 according to any method or combination of methods as described in the present disclosure. In particular, the control unit 8 is capable of receiving data from vehicle communication systems, various sensors located at the primary cooling circuit, heat source and/or emergency cooling unit, determining an operation status of the primary cooling circuit based on this data, and switching between different cooling operation modes, for examples a regular operation mode using the primary cooling circuit and the vehicle cooling circuit, and an emergency operation mode using an emergency cooling circuit within the liquid-cooled system.

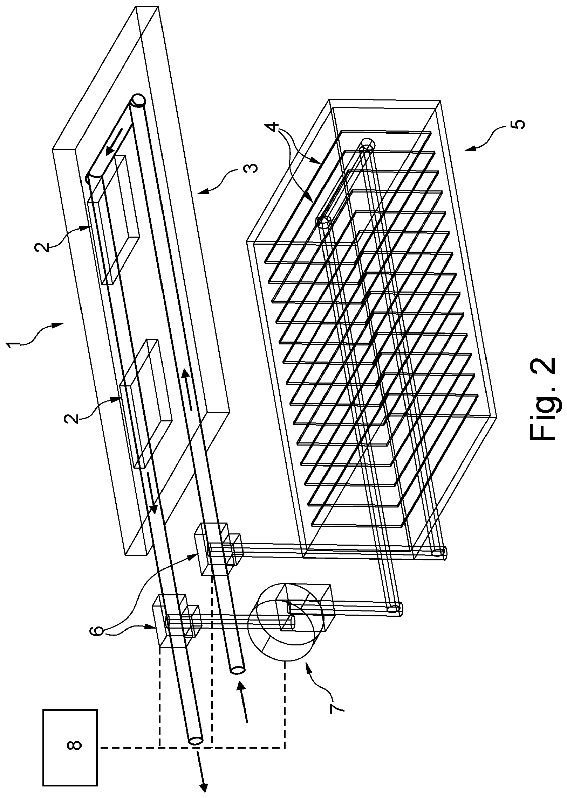

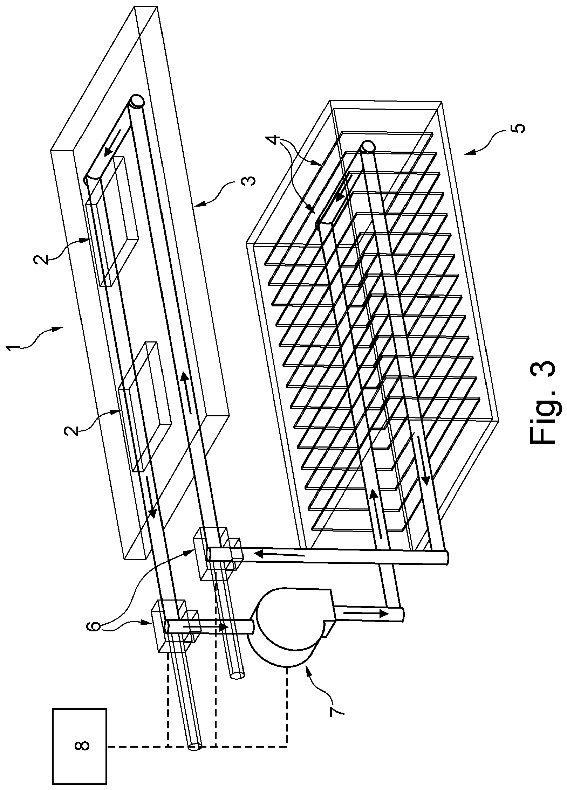

The liquid-cooled system 1 comprises an emergency cooling circuit, comprising an emergency cooling unit 5 and a pump 7, as well as pipes that connect to the emergency cooling unit 5 with the cold plate 3, which will be described in detail with reference to FIGs. 2 and 3 providing further details regarding the liquid-cooled system 1 of FIG. 1.

The emergency cooling circuit comprises an emergency cooling unit 5 containing a Phase Change Material (PCM) within a housing or containment structure. This housing thermally isolates the emergency cooling unit 5 from the surrounding environment and the primary cooling circuit. Within the emergency cooling unit 5, thermal fins 4 of a high-heat-conducting material are formed, which help to effectively transfer the heat from the cooling liquid to the PCM. The system 1 also includes a pair of distributor valves 6 mechanically linked to both the primary cooling circuit and the emergency cooling unit 5. These valves 6, under the control of a control unit (not shown), are capable of selectively disconnecting the cold plate 3 from the primary cooling circuit and connecting it to the emergency cooling unit 5, based on the monitored status of the primary cooling circuit, the emergency cooling unit 5, and the heat source 2. Thereby an emergency cooling circuit is be formed. A pump 7 is included in the emergency cooling circuit to circulate the cooling liquid within the emergency cooling circuit, once the distributor valves 6 connect the emergency cooling unit 5 to the cold plate 3.

FIG. 2 schematically illustrates the cooling liquid flow path during regular operation of the liquid-cooled system 1 of FIG. 1, according to various embodiments.

During this regular or regular operation mode, the cooling liquid is cooled in the primary cooling circuit, which is connected to the vehicle cooling circuit. Cooling liquid from in the vehicle cooling circuit is circulated through the cold plate and flows back into the vehicle cooling circuit, as indicated by the arrows. The distributor valves 6, set in their regular operation position, ensure a connection between the cold plate 3 and the primary cooling circuit, preventing the cooling liquid from entering the emergency cooling unit 5. The pump 7 is not operated. Therefore, cooling liquid is circulated through the cold plate 3 and transfers heat away from the heat sources 2.

FIG. 3 schematically illustrates the cooling liquid flow path during emergency operation of the liquid-cooled system 1 of FIG. 1, according to various embodiments.

Upon a failure in the primary cooling circuit, for example temperatures of the heat source 2 above a threshold temperature, or temperatures of the cooling liquid above such a limit - the distributor valves 6 disconnect the cold plate 3 from the primary cooling circuit and connect it to the emergency cooling unit 5, wherein the pump 7 is activated to circulate the cooling liquid through the cold plate 3. As indicated by the arrows, in this emergency operation mode, an emergency cooling circuit is formed within the liquid-cooled system 1. The cooling liquid is circulated only through the emergency cooling unit 5 and cooled by storing the heat within the emergency cooling unit 5, wherein the PCM absorbs heat from the cooling liquid, melts, and thereby maintains a constant temperature to cool the liquid as long as a phase change can be performed. In various examples, by switching to the emergency cooling circuit, operation of the critical components, which can be high-power or security relevant electronics, can be ensured for more than 10 minutes without operation of the primary cooling circuit.

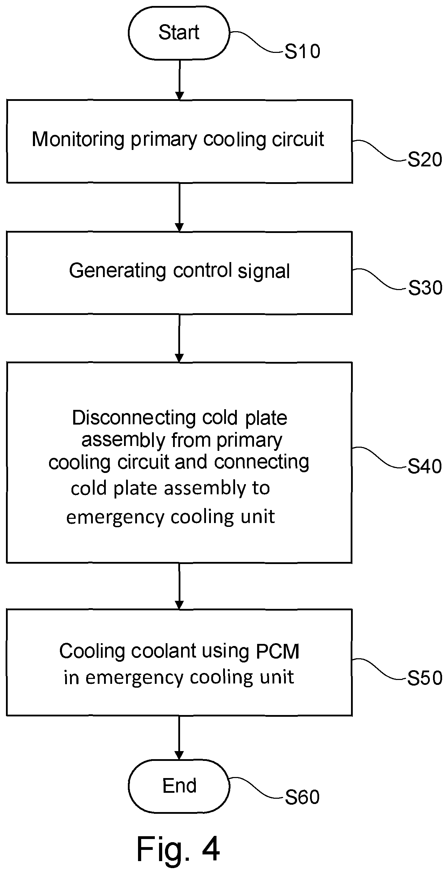

FIG. 4 illustrates steps of a method for emergency cooling that can be carried out by the liquid-cooled system 1 of FIG. 1, according to various embodiments.

The method starts in step S10. In step S20, the operation status of the primary cooling circuit is monitored through a control unit. This monitoring process may involve examining data from temperature sensors and cooling liquid flow rate sensors, as well as potentially other operational parameters of the primary cooling circuit. In step S30, based on the operation status determined in the previous step, a control signal is generated. This control signal might be produced due to a variety of triggers, such as detecting a failure in the primary cooling circuit or observing abnormal (i.e. not within predefined limits or thresholds) temperatures. In step S40, upon receipt of the control signal, by switching distributor valves, a cold plate assembly is disconnected from the primary cooling circuit. Concurrently, the cold plate assembly is connected to an emergency cooling unit. This emergency cooling unit contains a Phase Change Material (PCM) within a containment structure, providing an alternative cooling mechanism separate from the primary cooling circuit. In step S50, the cooling liquid is cooled using the PCM in the emergency cooling unit. The PCM absorbs heat from the cooling liquid and thereby performs a phase change, e.g., from solid to liquid in order to maintain a constant temperature to cool the liquid. The method ends in step S60.

Summarizing, a liquid-cooled system is designed for high heat density electronics in automotive applications. This system comprises a primary cooling circuit and a cold plate assembly thermally coupled to the heat source, which, in the present context, refers to high heat density electronics. The cooling liquid is circulated through this primary cooling circuit to dissipate the heat generated by the heat source.

An important feature of the present techniques is the inclusion of an emergency cooling circuit, or cycle, comprising an emergency cooling unit, housing a Phase Change Material (PCM). This PCM is designed to absorb heat at a constant temperature, thereby cooling the cooling liquid. This feature can prove to be particularly beneficial when the primary cooling system fails or stops working and can operate independently of other cooling systems or surrounding environment.

The PCM can be selected based on its specific melting point, which should ideally lie within the operational temperature range of the cooling liquid. When the cooling liquid, heated by the electronics or heat source it's intended to cool, comes into contact with the PCM, the latter absorbs the excess heat and undergoes a phase change - from solid to liquid. This phase transition is characterized by a substantial amount of energy that the PCM can absorb while maintaining its temperature constant, i.e., at its melting point.

Therefore, if the cooling liquid comes in at a temperature higher than the melting point of the PCM, it will transfer its excess heat to the PCM until it cools down to the melting point of the PCM. The PCM, while absorbing this heat, will start to melt but its temperature will remain constant, at its melting point, until it has fully melted. This allows the PCM to absorb a significant amount of heat without a corresponding increase in temperature, a property that is exploited to keep the cooling liquid at a relatively stable, predefined temperature range, even under high heat load conditions.

Thus, the use of PCM helps in providing an effective cooling buffer during emergency situations, enabling the electronics to continue operating safely for a prolonged period even if the primary cooling circuit fails or is disconnected.

The system further includes a pair of distributor valves that are mechanically linked to both the primary cooling circuit and the emergency cooling unit. These valves have the capability to disconnect the cold plate assembly from the primary cooling circuit and connect it to the emergency cooling unit in response to a control signal. This action is particularly significant during an emergency, when the primary cooling system might fail, potentially endangering crucial systems like the digital cockpit, body control, and autonomous driving, among others.

The ability to switch seamlessly between these two modes ensures that an emergency operation of the system can be maintained for a defined period. During this time, the driver can take over, or the vehicle can be safely moved to a safe area. This feature considerably enhances the safety and reliability of the liquid-cooled system and the vehicle it is installed in, particularly during emergency scenarios.

In conclusion, this liquid-cooled system integrates a secondary, fail-safe cooling system for high power, high heat density electronics in vehicles, thereby significantly improving the operational safety and reliability in potential emergency scenarios.

It is to be understood that the described techniques have been described with regard to a cooling system in a vehicle, however it is clear that they can be used with any system that comprises a liquid-cooled system. Similar techniques may be readily applied to other kinds and types of cooling systems, such as for example buildings, computing hardware, or electronic consumer devices.

Although the disclosed techniques have been described with respect to certain preferred embodiments, equivalents and modifications will occur to others skilled in the art upon the reading and understanding of the specification. The present disclosure includes all such equivalents and modifications and is limited only by the scope of the appended claims.

## Claims

1. A liquid-cooled system, comprising:
- a primary cooling circuit, through which a cooling liquid is circulated for heat removal;
- a cold plate assembly, which is thermally couplable to a heat source for transferring heat from the heat source to the cooling liquid;
- an emergency cooling unit comprising a Phase Change Material (PCM) housed within a containment structure;
- a pair of distributor valves, mechanically linked to the primary cooling circuit and the emergency cooling unit, configured to selectively disconnect the cold plate assembly from the primary cooling circuit and to connect the cold plate assembly to the emergency cooling unit in response to a control signal.

2. The liquid-cooled system of claim 1, further comprising a control unit, configured to:
- monitor at least one of the primary cooling circuit, the emergency cooling unit, and the heat source based on sensor data from sensors arranged at the respective elements;
- identify an emergency situation based on one or more of: a decrease of a pressure of the cooling liquid in the primary cooling circuit below a pressure threshold, a decrease of a flow rate of the cooling liquid in the primary cooling circuit below a flow rate threshold, and an increase of the temperature of the cooling liquid in the primary cooling circuit over a temperature threshold; and
- generate the control signal for enabling emergency operation based on the identified emergency situation.

3. The liquid-cooled system of claim 1 or 2, further configured to operate in:
- a regular operation mode, in which the cooling liquid is cooled by the primary cooling circuit and in which the distributor valves connect the cold plate assembly to the primary cooling circuit, and in which the distributor valves prevent cooling liquid from entering the emergency cooling unit; and
- an emergency operation mode, in which the distributor valves disconnect the cold plate assembly from the primary cooling circuit, in response to the control signal, and connect it to the emergency cooling unit, allowing the cooling liquid to be cooled by the emergency cooling unit.

4. The liquid-cooled system of claim 3, wherein the control unit is further configured to enable the emergency operation mode for a predetermined amount of time, in particular more than 10 minutes.

5. The liquid-cooled system of claim 4, wherein the control unit is further configured to determine the predetermined amount of time based on a thermal capacity of the cold plate assembly and/or or a thermal power loss of the heat source.

6. The liquid-cooled system of one of the preceding claims, wherein the liquid-cooled system is a liquid-cooled system onboard a vehicle, wherein the heat source comprises electronic circuits of an automotive computing device.

7. The liquid-cooled system of one of claims 2 to 6, wherein the control unit is further configured to progressively transition between the primary cooling circuit and the emergency cooling unit based on one or more of a rate of change in the pressure of the cooling liquid in the primary cooling circuit, and a decrease in cooling liquid flow rate of the primary cooling circuit.

8. The liquid-cooled system of one of the preceding claims, wherein the emergency cooling unit forms a local emergency cooling circuit with the cooling plate assembly, wherein the thermal energy is stored within the emergency cooling unit and not transferred to the primary cooling circuit.

9. The liquid-cooled system of one of claims 2 to 8, wherein the control unit is configured to monitor the pressure within the primary cooling circuit based on data received from a pressure sensor and generate the control signal based on the data from the pressure sensor.

10. The liquid-cooled system of one of the preceding claims, wherein the control unit is further configured to receive data from a temperature sensor within the emergency cooling unit and generate the control signal based on the data from the temperature sensor within the emergency cooling unit.

11. The liquid-cooled system of one of claims 2 to 10, wherein the control unit is configured to communicate with a user interface, providing an alert regarding an emergency situation of the cooling system or receive user input regarding an emergency situation of the primary cooling circuit.

12. The liquid-cooled system of one of the preceding claims, wherein the emergency cooling unit comprises a heat exchanger forming a plurality of cooling fins thermally coupled to the PCM.

13. The liquid-cooled system of one of the preceding claims, wherein the emergency cooling unit is sized based on the cooling capacity of the system during a predefined period of emergency operation, wherein the primary cooling circuit is not connected to the cold plate assembly.

14. A method for emergency cooling of a liquid-cooled system, comprising:
- monitoring a primary cooling circuit to identify an emergency situation of the primary cooling circuit;
- generating a control signal based on the identified emergency situation;
- transitioning the system to an emergency operation mode, by disconnecting a cold plate assembly thermally couplable to a heat source, from the primary cooling circuit and connecting the cold plate assembly to an emergency cooling unit containing a Phase Change Material housed within a containment structure in response to the control signal; and
- cooling the cooling liquid, during emergency operation, by the PCM in the emergency cooling unit for a predefined period of time.

15. The method for emergency cooling of a liquid-cooled system of claim 14, wherein the predetermined amount of time is determined based on based on a thermal capacity of the cold plate assembly and/or or a thermal power loss of the heat source.
